# EUROPEAN PATENT APPLICATION

(11) **EP 1 953 845 A1**
(43) Date of publication of application: **06.08.2008**
(21) Application number: 06833672.6
(22) Date of filing: 22.11.2006
(51) Int. Cl.: H01L 51/50, C08G 73/10, C09K 11/06

(54) **BLUE LIGHT-EMITTING DEVICE CONTAINING POLYIMIDE**

(30) Priority: 24.11.2005 JP 2005339482; 24.05.2006 JP 2006143952
(71) Applicant: JFE Chemical Corporation, Tokyo 111-0051 (JP)
(72) Inventor: HASEGAWA, Masatoshi, Taito-ku Tokyo 111-0051 (JP); NAKAO, Hiroaki, Taito-ku Tokyo 111-0051 (JP); YASUDA, Toshiyuki, Funabashi-shi Chiba 274-8510 (JP)
(74) Representative: HOFFMANN EITLE
(86) International application number: PCT/JP2006/323869
(87) International publication number: WO 2007/061122

(57) **Abstract**

A blue-light-emitting element includes a polyimide containing a repeating unit represented by formula (1): 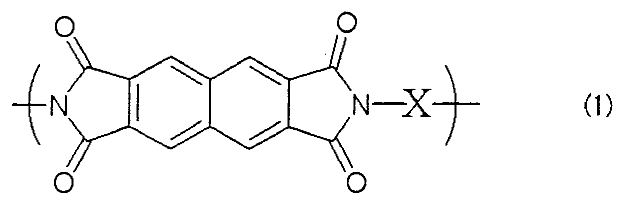 (wherein X represents a divalent alicyclic hydrocarbon group having 6 to 24 carbon atoms.)
Since this polyimide has a high glass transition temperature and toughness and exhibits a stable luminous efficiency, the blue-light-emitting element is suitable for an organic EL display.

## Description

### Technical Field

The present invention relates to a blue-light-emitting element comprising a polyimide. The blue-light-emitting element is suitable for organic electroluminescence (EL) displays.

### Background Art

Recently, organic EL full-color displays have been practically used and installed in cell phones, sub-panels of digital cameras, and the like. The panel size has also been increased from the three-inch class to the five-inch class, and the development of large screens such as television screens is expected in the future. At present, liquid crystal displays are mainly used as flat panel displays. However, since EL displays do not require polarizers, optical compensation films, and the like, which are used in the liquid crystal displays, the EL displays are significantly advantageous in that displays having a markedly small thickness and light weight can be produced, compared with the liquid crystal displays.

Organic EL displays fundamentally include three layers, namely, an electron-transporting layer, a light-emitting layer, and a hole-transporting layer; or two layers, namely, a light-emitting layer that also functions as an electron-transporting layer or a hole-transporting layer, and another layer. In order to drive organic EL displays with a low voltage, a highly controlled technique for forming thin films is essential. Organic EL elements are classified into low-molecular-weight EL elements and high-molecular-weight EL elements (i.e., polymer EL elements). The former EL elements are produced by a dry process such as organic molecular beam deposition, whereas the latter EL elements can be produced by a wet process such as a spin coating method or a dip coating method. Accordingly, the high-molecular-weight EL elements are advantageous in that the production apparatus is simpler and uniform thin films having a large area can be produced with a high productivity and a low cost, compared with the low-molecular-weight EL elements.

Recently, an ink jet printing method, which is widely employed for printers used with personal computers, has attracted attention as the wet process. By employing this method, highly precise patterning can be realized, the amount of waste of a solution can be decreased, and a multicolor display has also been realized. Consequently, the wet process has become more advantageous.

Another advantage of the high-molecular-weight EL elements is that they have a high mechanical strength and flexibility. Accordingly, when a polymer material is used as a substrate instead of glass, a flexible EL display having a high impact resistance can also be produced. In addition, in the high-molecular-weight EL elements, crystallization and aggregation do not easily occur compared with the low-molecular-weight EL elements. Therefore, the storage and the use of the high-molecular-weight EL elements under high-temperature conditions can be expected.

Low-molecular-weight dye evaporated films for low-molecular-weight EL elements can provide uniform amorphous films. However, when an EL element including such a film is exposed to a high-temperature condition for outdoor use, automobile use, or the like, when such an EL element is driven under a high-temperature condition, or when Joule heat or the like is generated during the driving of the EL element, crystallization and aggregation often occur, resulting in a marked decrease in the stability of the EL element. Recently, in order to improve the heat resistance of EL elements, studies aiming to increase the glass transition temperatures of low-molecular-weight dye evaporated films as much as possible have been conducted. From this point of view, the use of a polymer layer having high heat resistance instead of using such a low-molecular-weight dye is also expected.

For example, if an electron-transporting group, a hole-transporting group, and/or a light-emitting group are bonded to a heat-resistant polymer and aggregation of these functional groups can be suppressed, the driving lifetime of EL elements can be markedly increased.

Known examples of a heat-resistant polymer material having an extremely high glass transition temperature include polyimides, polybenzoxazoles, polybenzimidazoles, and polymaleimides (for example, Japanese Unexamined Patent Application Publication No. 2005-267935). From the standpoint of the simplicity of the production method, the ease of forming thin films, the purity of films, and heat resistance, and the like, polyimides are most preferred. However, polyimides for practical use in which the carrier-transport characteristics, the light-emitting characteristics, and the like are controlled are very few. The reason for this is as follows. It is essential that strong photoluminescence (PL) be exhibited in order to realize EL. However, in general, wholly aromatic polyimides are significantly colored because of intramolecular or intermolecular charge transfer interaction (for example, Progress in Polymer Science, 26, 259 to 335 (2001)). Furthermore, wholly aromatic polyimides are non-fluorescent, and wholly aromatic polyimides for practical use that exhibit strong PL are very few.

In addition, polymaleimides whose side chain is substituted with a naphthalene ring have unsatisfactory heat resistance, and thus the heat treatment temperature cannot be increased.

It is an object of the present invention to solve the problems of the related art and to provide a blue-light-emitting element comprising a polyimide having a high glass transition temperature, toughness, and photoluminescence.

### Disclosure of Invention

The present invention provides a blue-light-emitting element comprising a polyimide containing a repeating unit represented by formula (1): 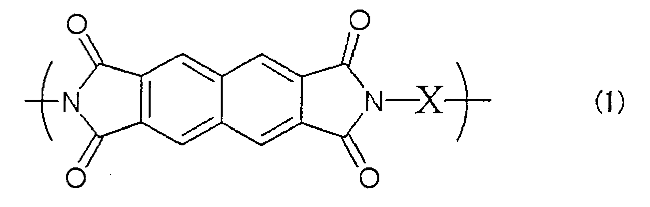 (wherein X represents a divalent alicyclic hydrocarbon group having 6 to 24 carbon atoms.)

The blue-light-emitting element preferably contains a polyimide prepared by performing an imidization reaction of a polyimide precursor having an intrinsic viscosity of 0.5 dl/g or more under heating or in the presence of a dehydrating agent.

The blue-light-emitting element according to any one of the above preferably contains a polyimide having a glass transition temperature of 250°C or higher and toughness.

### Brief Description of the Drawings

Fig. 1 is an infrared absorption spectrum of a polyimide precursor film of Example 1.
Fig. 2 is an infrared absorption spectrum of a polyimide film of Example 1.

### Best Mode for Carrying Out the Invention

Embodiments of the present invention will now be described specifically. However, these are examples of embodiments of the present invention, and the present invention is not limited thereto.

A polyimide contained in a blue-light-emitting element of the present invention contains a repeating unit represented by formula (1): 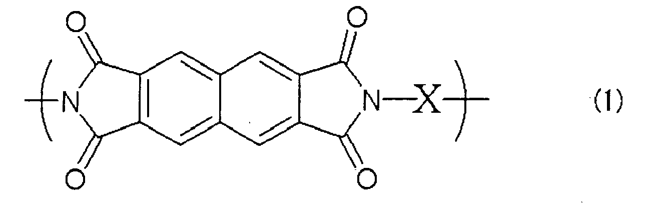 (wherein X represents a divalent alicyclic hydrocarbon group having 6 to 24 carbon atoms.)

The phrase "contains a repeating unit represented by formula (1)" means that it is sufficient that the repeating unit is contained in a part of the polyimide. Accordingly, the polyimide of the present invention may be a copolyimide.

The "repeating unit represented by formula (1)" is obtained by, for example, a reaction between an alicyclic diamine having 6 to 24 carbon atoms and 2,3,6,7-naphthalenetetracarboxylic acid and/or a derivative of 2,3,6,7-naphthalenetetracarboxylic acid.

The derivative of 2,3,6,7-naphthalenetetracarboxylic acid means a derivative of the carboxyl groups disposed at the 2nd position, the 3rd position, the 6th position, and the 7th position of 2,3,6,7-naphthalenetetracarboxylic acid. Examples of such a derivative of the carboxyl groups include esters of the carboxylic acid, anhydrides of the carboxylic acid, and halides of the carboxylic acid.

The carboxyl groups disposed at the 2nd position, the 3rd position, the 6th position, and the 7th position of 2,3,6,7-naphthalenetetracarboxylic acid may be the same derivative groups or different derivative groups.

A plurality types of derivatives of 2,3,6,7-naphthalenetetracarboxylic acid may be mixed and used.

2,3,6,7-Naphthalenetetracarboxylic acid and a derivative of 2,3,6,7-naphthalenetetracarboxylic acid described above may have a substituent so long as the object of the present invention is not impaired.

Among these derivatives of carboxyl groups, anhydrides of the carboxylic acid are preferred. In view of the reactivity, the formability in the subsequent steps, and the like, in particular, 2,3,6,7-naphthalenetetracarboxylic dianhydride is preferably used.

The present invention will be described below with a reaction example using 2,3,6,7-naphthalenetetracarboxylic dianhydride.

A polyimide containing the repeating unit represented by formula (1) is produced by, for example, a method described below using 2,3,6,7-naphthalenetetracarboxylic dianhydride.

First, an alicyclic diamine having 6 to 24 carbon atoms is dissolved in a polymerization solvent. A powder of 2,3,6,7-naphthalenetetracarboxylic dianhydride is gradually added to the resulting solution, and the reaction mixture is stirred at room temperature in the range of 1 to 72 hours, preferably 3 to 20 hours, to perform a polymerization reaction. Thus, a polyamic acid, which is a polyimide precursor, is prepared.

In this step, the monomer concentration is adjusted in the range of 5 to 30 mass percent, preferably, 10 to 20 mass percent. A monomer concentration less than 5 mass percent is not preferable because the degree of polymerization of the polyimide precursor is not satisfactorily high and the finally obtained polyimide film may become brittle. On the other hand, when the monomer concentration exceeds 30 mass percent, it takes a longer time to dissolve the resulting salt, and the productivity may be decreased. Accordingly, in order to prevent the above problems, the polymerization is preferably performed in the monomer concentration range of 5 to 30 mass percent. From the standpoint that a uniform polyimide precursor having a high degree of polymerization is obtained, polymerization is preferably performed in the above concentration range.

The resulting polyamic acid, which is a polyimide precursor, is subjected to cyclodehydration under heating or in the presence of a dehydrating agent and converted into a polyimide.

For the purpose of this description, the term "imidization reaction" means a reaction in which a polyamic acid, which is the polyimide precursor, or a derivative thereof is cyclized by a condensation reaction to convert it into a polyimide. When 2,3,6,7-naphthalenetetracarboxylic dianhydride is used, this cyclocondensation reaction is a cyclodehydration reaction.

Examples of the 2,3,6,7-naphthalenetetracarboxylic acid derivative used in the production of the polyimide precursor of the present invention include diester dihalides of 2,3,6,7-naphthalenetetracarboxylic acid and naphthalenetetracarboxylic dianhydride having substituents of an alkyl group having 1 to 5 carbon atoms or a halogen atom at the 1st position, the 4th position, the 5th position, and the 8th position.

When 1,4,5,8-naphthalenetetracarboxylic dianhydride, which is an isomer of 2,3,6,7-naphthalenetetracarboxylic dianhydride, is used, the polymerization reaction with an alicyclic diamine having 6 to 24 carbon atoms is not carried out, and a desired polyimide precursor cannot be obtained.

When the polyimide of the present invention is a copolyimide, various types of tetracarboxylic dianhydrides can be used for producing a polyimide precursor of the present invention coexisting with 2,3,6,7-naphthalenetetracarboxylic dianhydride and a derivative thereof as long as the polymerization reactivity for producing the polyimide precursor and characteristics required for the polyimide produced by an imidization reaction (cyclization reaction) are not significantly impaired. Some of the carbon atoms forming the ring may be substituted with a halogen atom, an alkyl group, or the like.

In the blue-light-emitting element of the present invention, satisfactory luminescence characteristics can be achieved as long as the repeating unit represented by formula (1) is contained. Even when a comonomer other than 2,3,6,7-naphthalenetetracarboxylic dianhydride is used and the concentration of a luminescent group (2,3,6,7-naphthalenetetracarboxydiimide group) is decreased, satisfactorily strong blue-light emission can be achieved.

When copolymerization is performed, the amount of 2,3,6,7-naphthalenetetracarboxylic dianhydride used as a luminescent component is in the range of 0.1 to 100 mole percent, more preferably 1 to 80 mole percent, and further preferably 2 to 50 mole percent. When the concentration of the luminescent group is adequately decreased by means of copolymerization as described above, aggregation of the luminescent groups can be suppressed to intensify the blue-light emission. In such a case, the types of tetracarboxylic dianhydride used as a comonomer is not particularly limited, but alicyclic tetracarboxylic dianhydrides are preferred in view of the photoluminescence yield.

Examples of the copolymerizable alicyclic tetracarboxylic dianhydride include bicyclo[2.2.2]oct-7-ene-2,3,6,7-tetracarboxylic dianhydride, 5-(dioxotetrahydrofuryl)-3-methyl-3-cyclohexene-1,2-dicarboxylic anhydride, 4-(2,5-dioxotetrahydrofuran-3-yl)tetralin-1,2-dicarboxylic anhydride, tetrahydrofuran-2,3,4,5-tetracarboxylic dianhydride, bicyclo-3,3' ,4,4'-tetracarboxylic dianhydride, 3c-carboxymethyl-cyclopentane-1r, 2c, 4c-tricarboxylic acid-1,4:2,3-dianhydride, 1,2,4,5-cyclohexanetetracarboxylic dianhydride, 1,2,3,4-cyclobutanetetracarboxylic dianhydride, and 1,2,3,4-cyclopentanetetracarboxylic dianhydride. These may be used in combinations of two or more compounds.

The ratio of a copolymerizable aromatic tetracarboxylic dianhydride component to 2,3,6,7-naphthalenetetracarboxylic dianhydride is preferably 20 mole percent or less.

Examples of the aromatic tetracarboxylic dianhydride include 3,3',4,4'-biphenyltetracarboxylic dianhydride, 3,3',4,4'-benzophenonetetracarboxylic dianhydride, 3,3',4,4'-biphenylethertetracarboxylic dianhydride, 3,3',4,4'-biphenylsulfonetetracarboxylic dianhydride, 2,2'-bis(3,4-dicarboxyphenyl)hexafluoropropanoic dianhydride, 2,2'-bis(3,4-dicarboxyphenyl)propanoic dianhydride, and 1,4,5,8-naphthalenetetracarboxylic dianhydride. These may be used in combinations of two or more compounds.

Various types of alicyclic diamines having 6 to 24 carbon atoms can be used for producing a polyimide precursor of the present invention as long as the polymerization reactivity for producing the polyimide precursor and characteristics required for a polyimide produced by an imidization reaction (cyclization reaction) are not significantly impaired. For example, some of the carbon atoms forming the ring may be substituted with a halogen atom.

Specific examples of the alicyclic diamine having 6 to 24 carbon atoms and used in the present invention are described below.

Examples thereof include bicyclic diamines in which alicyclic groups are bonded via an alkylene group, such as 4,4'-methylenebis(cyclohexylamine), 4,4'-methylenebis(3,3'-dimethylcyclohexylamine), 2,2-bis (4-aminocyclohexyl)propane, and 2,2-bis(4-aminocyclohexyl)hexafluoropropane; monocyclic diamines such as isophoronediamine, trans-1,4-cyclohexanediamine, cis-1,4-cyclohexanediamine, 1,4-cyclohexanediamine (a mixture of the trans-isomer and the cis-isomer), and 1,4-cyclohexane bis(methylamine); and multi-cyclo diamines such as 2,5-bis(aminomethyl)bicyclo[2.2.1]heptane, 2,6-bis(aminomethyl)bicyclo[2.2.1]heptane, 3,8-bis(aminomethyl)tricyclo[5.2.1.0]decane, and 1,3-diaminoadamantane. These may be used in combinations of two or more compounds.

Among these, 4,4'-methylenebis(cyclohexylamine), trans-1,4-cyclohexanediamine, and the like are preferred. Polyimide precursors obtained using 4,4'-methylenebis(cyclohexylamine) are novel compounds.

When the polyimide of the present invention is a copolyimide, various types of diamines can be used for producing a polyimide precursor of the present invention coexisting with an alicyclic diamine having 6 to 24 carbon atoms as long as the polymerization reactivity for producing the polyimide precursor and characteristics required for a polyimide produced by an imidization reaction (cyclization reaction) are not significantly impaired. Some of the carbon atoms forming the ring may be substituted with a halogen atom, an alkyl group, or the like. The ratio of the copolymerizable component to the alicyclic diamine is equimolar amount or less, and preferably 20 mole percent or less.

Specific examples of the copolymerizable component are as follows.

Examples of aliphatic diamines include 1,3-propanediamine, 1,4-tetramethylenediamine, 1,5-pentamethylenediamine, 1,6-hexamethylenediamine, 1,7-heptamethylenediamine, 1,8-octamethylenediamine, and 1,9-nonamethylenediamine. These may be used in combinations of two or more compounds.

Examples of aromatic diamines include p-phenylenediamine, m-phenylenediamine, 2,4-diaminotoluene, 2,5-diaminotoluene, 2,4-diaminoxylene, 2,4-diaminodurene,-4,4'-diaminodiphenylmethane, 4,4'-methylenebis(2-methylaniline), 4,4'-methylenebis(2-ethylaniline), 4,4'-methylenebis(2,6-dimethylaniline), 4,4'-methylenebis(2,6-diethylaniline), 4,4'-diaminodiphenyl ether, 3,4'-diaminodiphenyl ether, 3,3'-diaminodiphenyl ether, 2,4'-diaminodiphenyl ether, 4,4'-diaminodiphenylsulfone, 3,3'-diaminodiphenylsulfone, 4,4'-diaminobenzophenone, 3,3'-diaminobenzophenone, 4,4'-diaminobenzanilide, benzidine, 3,3'-dihydroxybenzidine, 3,3'-dimethoxybenzidine, o-tolidine, m-tolidine, 2,2'-bis(trifluoromethyl)benzidine, 1, 4-bis (4-aminophenoxy)benzene, 1,3-bis(4-aminophenoxy)benzene, 1,3-bis(3-aminophenoxy)benzene, 4,4'-bis(4-aminophenoxy)biphenyl, bis[4-(3-aminophenoxy)phenyl]sulfone, bis[4-(4-aminophenoxy)phenyl]sulfone, 2,2-bis[4-(4-aminophenoxy)phenyl]propane, 2,2-bis[4-(4-aminophenoxy)phenyl]hexafluoropropane, 2,2-bis(4-aminophenyl)hexafluoropropane, and p-terphenylenediamine. These may be used in combinations of two or more compounds.

Examples of preferable aromatic diamines include 4,4'-oxydianiline, p-phenylenediamine, m-tolidine, and 2,2'-bis(trifluoromethyl)benzidine.

The polymerization solvent used in the production of the polyimide precursor is not particularly limited as long as the solvent can dissolve the tetracarboxylic dianhydride and the alicyclic diamine that are used as raw material monomers, but protic solvents are preferred. Specific examples of the solvents include aprotic solvents such as N,N-dimethylacetamide, N,N-diethylacetamide, N,N-dimethylformamide, N-methyl-2-pyrrolidone, hexamethylphosphoramide, dimethyl sulfoxide, γ-butyrolactone, 1,3-dimethyl-2-imidazolidinone, 1, 2-dimethoxyethanebis (2-methoxyethyl) ether, tetrahydrofuran, 1,4-dioxane, picoline, pyridine, acetone, chloroform, toluene, and xylene; and protic solvents such as phenol, o-cresol, m-cresol, p-cresol, o-chlorophenol, m-chlorophenol, and p-chlorophenol. Among these, N-methyl-2-pyrrolidone and N,N-dimethylacetamide are preferably used. These solvents may be used alone or as a mixture of two or more solvents.

The polyimide of the present invention is normally appropriately formed and used for the blue-light-emitting element of the present invention. In general, the polyimide is formed into a thin film and used for the blue-light-emitting element.

The intrinsic viscosity of the resulting polyimide precursor (polyamic acid) is preferably as high as possible. More preferably, the intrinsic viscosity of the polyimide precursor is 0.5 dl/g or more, and further preferably, 1.0 dl/g or more. When the intrinsic viscosity is less than 0.5 dl/g, the film-formation property is significantly degraded and cracks and the like may be generated in the cast film. When the intrinsic viscosity is excessively high, the handleability is degraded. Accordingly, the upper limit of the intrinsic viscosity is about 5.0 dl/g.

A solution containing the polyimide precursor is applied on a substrate or a hole-transporting layer provided on a substrate and then dried in the range of 40°C to 150°C, thus forming a polyimide precursor film. The resulting film is then heat-treated in the range of 200°C to 400°C, preferably 220°C to 350°C, thereby carrying out an imidization (cyclization) reaction. Thus, a polyimide film is obtained. That is, a blue-light-emitting element containing the polyimide is obtained.

When the heat treatment temperature for imidization is lower than 200°C, for example, the imidization reaction may not be completely carried out, which is not preferable. On the other hand, a heat treatment temperature higher than 400°C is also not preferable because the resulting polyimide film may be colored or a part of the polyimide film may be thermally decomposed. The thermal imidization reaction is preferably performed in vacuum or in an inert gas atmosphere such as a nitrogen atmosphere. The thermal imidization reaction may be performed in air as long as the temperature is not excessively high.

The imidization reaction can also be performed using a dehydrating agent. For example, a dehydrating agent such as N,N-dicyclohexylcarbodiimide, acetic anhydride, or trifluoroacetic anhydride is added to a solution of a polyimide precursor. The mixture is stirred in the presence of pyridine or a tertiary amine such as triethylamine to perform a dehydration reaction in the range of 0°C to 100°C, preferably 0°C to 60°C. The resulting polyisoimide solution (varnish) is formed into a film by the same method as that described above, followed by a heat treatment in the range of 250°C to 450°C, preferably 270°C to 400°C. Thus, the film can be easily converted into a polyimide film.

The imidization (cyclization) can be confirmed by the infrared absorption spectrum.

Alternatively, the solution (varnish) of the polyimide precursor of the present invention may be heated in the range of 150°C to 200°C without further treatment or after the solution is adequately diluted with the same solvent in advance. Accordingly, a polyimide solution of the present invention can be easily produced. In this case, toluene, xylene, or the like may be added in order to azeotropically distill off water or the like, which is a byproduct of the imidization reaction. In addition, a base such as γ-picoline may be added as a catalyst.

The polyimide solution may be added dropwise in a large amount of solvent that does not dissolve the polyimide, such as water or methanol, and the mixture may then be filtered. Thus, the polyimide can be isolated as a powder. Furthermore, the resulting polyimide powder may be dissolved again in the polymerization solvent to produce a polyimide varnish.

The above polyimide solution may be applied on a substrate and then dried in the range of 40°C to 400°C, preferably 100°C to 250°C, thus forming a polyimide film. This polyimide film can also be used for a blue-light-emitting element.

Alternatively, the above polyimide powder may be compressed under heating in the range of 200°C to 450°C, and preferably 250°C to 430°C to form a polyimide compact. This polyimide compact can also be used for a blue-light-emitting element.

Additives such as an oxidation stabilizer, a filler, a silane coupling agent, a photosensitive agent, a photopolymerization initiator, and a sensitizer may be added to the polyimide or the polyimide precursor as needed. These additives can be used in a blue-light-emitting element.

### EXAMPLES

The present invention will now be specifically described using examples, but the present invention is not limited to these examples. Physical property values in the examples below were measured by the following methods. A polyimide film having a thickness of 20 µm was used for the evaluation of the physical properties of the film.

### <Intrinsic viscosity>

The intrinsic viscosity was measured using a 0.5 wt% polyimide precursor solution (solvent: N,N-dimethylacetamide) with an Ostwald viscometer at 30°C.

### <Glass transition temperature: Tg>

Dynamic viscoelasticity was measured with a thermomechanical analyzer (TMA 4000) manufactured by Bruker AXS K.K. The glass transition temperature of a polyimide film was determined from the loss peak at a frequency of 0.1 Hz and at a temperature-increasing rate of 5°C/min.

### <Coefficient.of linear thermal expansion: CTE>

Thermomechanical analysis was performed with a thermomechanical analyzer (TMA 4000) manufactured by Bruker AXS K.K. The coefficient of linear thermal expansion of a polyimide film was determined as an average in the range of 100°C to 200°C from the elongation of a test piece at a rate of load 0.5 g/film thickness 1 µm and at a temperature-increasing rate of 5°C/min.

### <5%-Weight-decrease temperature: Td⁵>

The temperature at which the initial weight of a polyimide film is decreased by 5% in a temperature-increasing process at a temperature-increasing rate of 10°C/min in nitrogen or in air was measured with a thermogravimetric analyzer (TG-DTA 2000) manufactured by Bruker AXS K.K. A higher value of this temperature means a higher thermal stability.

### <Birefringence>

The refractive indices of a polyimide film in a direction parallel to the film (nᵢₙ) and in a direction perpendicular to the film (nₒᵤₜ) were measured with an Abbe refractometer (Abbe 4T) manufactured by Atago Co., Ltd. (using a sodium lamp, wavelength: 589 nm). The birefringence (△n = nᵢₙ - nₒᵤₜ) was determined from the difference in these refractive indices.

### <Dielectric constant>

The dielectric constant (εcal) of a polyimide film at 1 MHz was calculated with an Abbe refractometer (Abbe 4T) manufactured by Atago Co., Ltd. on the basis of the average refractive index [nₐᵥ = (2nᵢₙ + nₒᵤₜ)/3)] of the polyimide film using an equation of εcal = 1.1 x nₐᵥ².

### <Cutoff wavelength (transparency)>

The visible and ultraviolet transmittance of a polyimide film was measured in the range of 200 to 900 nm with an ultraviolet-visible spectrophotometer (V-520) manufactured by JASCO Corporation. The wavelength (cutoff wavelength) at which the transmittance was 0.5% or less was used as an indicator of transparency. A shorter cutoff wavelength means that the transparency of the polyimide film is more satisfactory.

### <Light transmittance (transparency)>

The light transmittance at 400 nm of a polyimide film was measured with an ultraviolet-visible spectrophotometer (V-520) manufactured by JASCO Corporation. A higher transmittance means that the transparency of the polyimide film is more satisfactory.

### <Water absorption>

A polyimide film (having a thickness in the range of 20 to 30 µm) dried in vacuum at 50°C for 24 hours was immersed in water at 25°C for 24 hours, and water remaining on the surface of the polyimide film was then wiped off. The water absorption (%) was determined from the increase in the mass of the film.

### <Modulus of elasticity and breaking elongation>

A tensile test (stretching speed: 8 mm/min) of a test piece of a polyimide film (3 mm x 30 mm) was performed with a tensile tester (Tensilon UTM-2) manufactured by Toyo Baldwin Co., Ltd. The modulus of elasticity was determined from the initial slope of the stress-strain curve, and the breaking elongation (%) was determined from the elongation percentage at which the film was broken. A higher breaking elongation means a higher toughness of the film.

### <Emission spectrum and quantum yield>

An emission spectrum of a polyimide film was measured with a fluorospectrophotometer (Hitachi, Ltd., F-4500) at an excitation wavelength of 350 nm, a bandpass at the excitation side of 5 nm, a bandpass at the detection side of 5 nm, and at room temperature. An integrated intensity of the emission spectrum normalized with the absorbance at the excitation wavelength was determined. A photoluminescence (PL) quantum yield of the polyimide film was determined by a relative method from a comparison with a normalized integrated intensity of N,N-bis(2,5-tert-butylphenyl)3,4,9,10-perylenedicarboxyimide (fluorescence quantum yield φ = 0.95), which is a standard material dispersed in a polymethylmethacrylate film.

### <Infrared absorption spectrum>

Infrared absorption spectra of a polyimide precursor thin film and a polyimide thin film (thickness: about 5 µm) were measured with a Fourier transform infrared spectrophotometer (FT-IR 5300, manufactured by JASCO Corporation) by a transmission method.

### (EXAMPLE 1)

First, 15 mmol of 4,4'-methylenebis(cyclohexylamine) (MBCHA) (manufactured by Tokyo Chemical Industry Co., Ltd., an isomer mixture) was charged in a closed reactor equipped with a stirrer and dissolved in 43 mL of N,N-dimethylacetamide that had been sufficiently dehydrated with molecular sieves 4A. Subsequently, 15 mmol of a powder of 2,3,6,7-naphthalenetetracarboxylic dianhydride (NTCDA, manufactured by JFE Chemical Corporation) was gradually added to the solution. Polymerization was initiated at a solute concentration of 15 mass percent. The reaction solution was gradually diluted so that the final concentration was decreased to 8.5 mass percent. The solution was stirred at room temperature for 26 hours, thus allowing a transparent, uniform, viscous polyimide precursor solution to be prepared. Even when this polyimide precursor solution was left to stand at room temperature and at -20°C for one month, precipitation and gelation did not occur at all, thus exhibiting extremely high solution storage stability. The intrinsic viscosity of the polyimide precursor measured in N,N-dimethylacetamide at 30°C was 1.942 dl/g.

The polymerization solution was applied onto a glass substrate and then dried at 60°C for two hours to prepare a polyimide precursor film having toughness. This polyimide precursor film was heated stepwise on the substrate in vacuum at 200°C for one hour, and then at 300°C for one hour to perform imidization. Accordingly, a flexible polyimide film having a thickness of 20 µm was obtained.

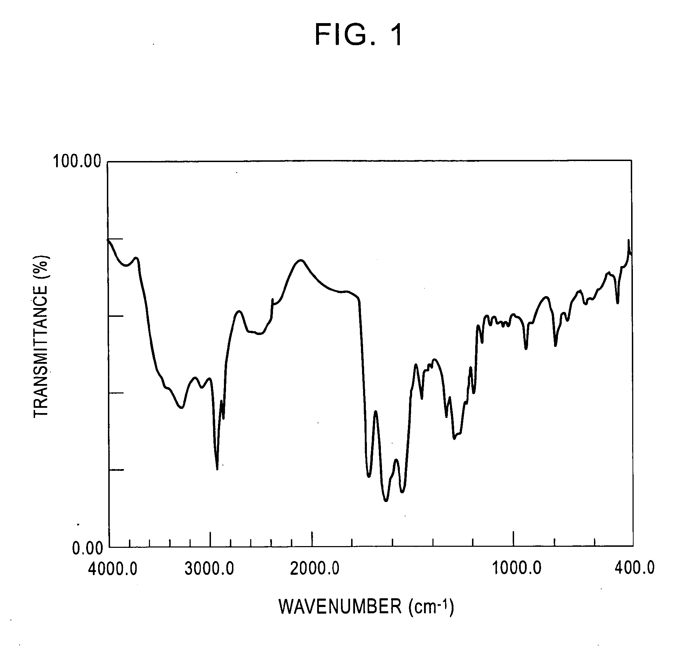

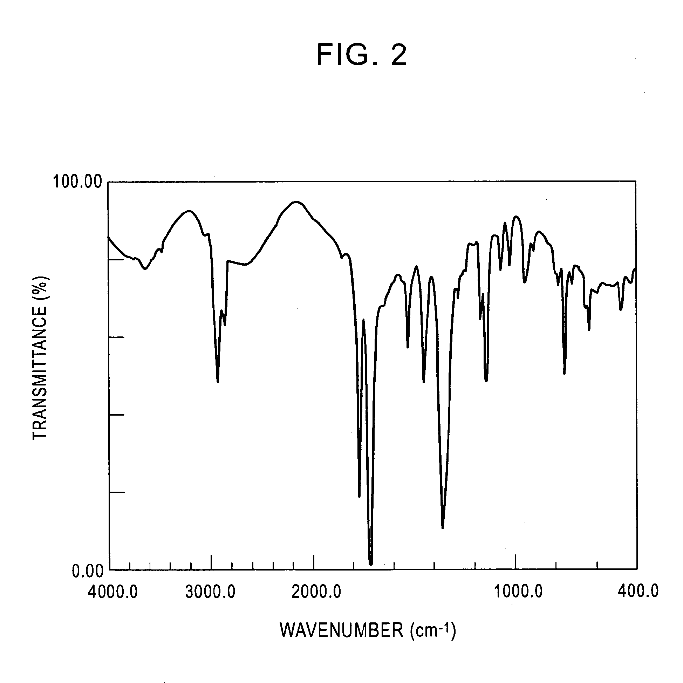

When a 180°-bending test was performed, breaking of the film was not observed, and thus high toughness was exhibited. The polyimide film had a glass transition temperature (Tg) of 376°C and a coefficient of linear thermal expansion (CTE) of 45.2 ppm/K. The 5%-weight-decrease temperature in nitrogen (Td⁵N₂) was 465°C, and that in air (Td⁵air) was 403°C. Thus, the polyimide film exhibited high thermal stability. This polyimide film exhibited blue-light emission (excitation wavelength: 350 nm) having a peak at 406 nm, and the photoluminescence quantum yield was 0.0143. The birefringence of this polyimide film was 0.0343. Fig. 1 shows an infrared absorption spectrum of the polyamic acid thin film, and Fig. 2 shows an infrared absorption spectrum of the polyimide thin film.

### (EXAMPLE 2)

Polymerization was performed in accordance with the method described in Example 1 except that 1,2,3,4-cyclobutanetetracarboxylic dianhydride (hereinafter referred to as CBDA, synthesized by photodimerization of maleic anhydride by ultraviolet irradiation in ethyl acetate) was used as a comonomer together with 2,3,6,7-naphthalenetetracarboxylic dianhydride (NTCDA). Imidization was then performed by heating, thus allowing a copolyimide film to be prepared. The copolymer composition was NTCDA/(CBDA + NTCDA) = 0.5. The solution of the copolyimide precursor obtained by the polymerization exhibited extremely high solution storage stability. The intrinsic viscosity of the polyamic acid was 0.761 dl/g. Physical properties of the copolyimide film are summarized in Table 1.

### (EXAMPLE 3)

Polymerization was performed in accordance with the method described in Example 1 except that 1,2,3,4-cyclobutanetetracarboxylic dianhydride (CBDA) was used as a comonomer together with 2,3,6,7-naphthalenetetracarboxylic dianhydride (NTCDA). Imidization was then performed by heating, thus allowing a copolyimide film to be prepared. The copolymer composition was NTCDA/(CBDA + NTCDA) = 0.1. The solution of the copolyimide precursor obtained by the polymerization exhibited extremely high solution storage stability. The intrinsic viscosity of the polyamic acid was 0.638 dl/g. Physical properties of the copolyimide film are summarized in Table 1.

### (EXAMPLE 4)

Polymerization was performed in accordance with the method described in Example 1 except that 1,2,3,4-cyclobutanetetracarboxylic dianhydride (CBDA) was used as a comonomer together with 2,3,6,7-naphthalenetetracarboxylic dianhydride (NTCDA). Imidization was then performed by heating, thus allowing a copolyimide film to be prepared. The copolymer composition was NTCDA/(CBDA + NTCDA) = 0.02. The solution of the copolyimide precursor obtained by the polymerization exhibited extremely high solution storage stability. The intrinsic viscosity of the polyamic acid was 0.693 dl/g. Physical properties of the copolyimide film are summarized in Table 1.

### (EXAMPLE 5)

Polymerization was performed in accordance with the method described in Example 1 except that 4,4'-methylenebis(3-methylcyclohexylamine) (MBMCHA) was used as the diamine component instead of 4,4'-methylenebis(cyclohexylamine) (isomer mixture). Imidization was then performed by heating, thus allowing a polyimide film to be prepared. The solution of the polyimide precursor obtained by the polymerization exhibited extremely high solution storage stability. The intrinsic viscosity of the polyamic acid was 2.00 dl/g. Physical properties of the polyimide film are summarized in Table 1.

### (EXAMPLE 6)

Polymerization was performed in accordance with the method described in Example 1 except that 4,4'-methylenebis(cyclohexylamine) (trans-trans isomer, t-MBCHA) was used as the diamine component instead of 4,4'-methylenebis(cyclohexylamine) (isomer mixture). Imidization was then performed by heating, thus allowing a polyimide film to be prepared. The solution of the polyimide precursor obtained by the polymerization exhibited extremely high solution storage stability. The intrinsic viscosity of the polyamic acid was 1.503 dl/g. Physical properties of the polyimide film are summarized in Table 1.

### (COMPARATIVE EXAMPLE 1)

Polymerization was performed in accordance with the method described in Example 1 except that 1,4,5,8-naphthalenetetracarboxylic dianhydride (1458NTCDA) was used instead of 2,3,6,7-naphthalenetetracarboxylic dianhydride. However, although the polymerization solution was stirred at room temperature for 200 hours, the polymerization solution did not become uniform and polymerization was not carried out.

### (COMPARATIVE EXAMPLE 2)

Polymerization was performed in accordance with the method described in Example 3 except that 1,4,5,8-naphthalenetetracarboxylic dianhydride (1458NTCDA) was used instead of 2,3,6,7-naphthalenetetracarboxylic dianhydride. Thus, a polyamic acid having an intrinsic viscosity of 0.646 dl/g was prepared. However, a copolyimide film obtained by imidizing the polyamic acid under heating was brittle. Physical properties of the copolyimide film are summarized in Table 1. This copolyimide film was almost non-fluorescent, and intended blue-light emission was not performed. This is because 2,3,6,7-naphthalenetetracarboxylic dianhydride was not used as a monomer.

When the blue-light-emitting element of the present invention is, for example, an element prepared by forming a polyimide film on a substrate, the element achieves blue-light emission and has a high glass transition temperature and toughness. Accordingly, the blue-light-emitting element of the present invention is useful as a luminescent material for an organic EL element.

**Table 1**

| | Intrinsic viscosity (dl/g) | Tg (°C) | CTE (ppm/K) | Birefring ence | Dielectric constant | Modulus of elasticity (GPa) | Breaking elongation (%) | Water absorpt ion (%) | T% at 400 nm | Cutoff (nm) | Td⁵N₂ (°C) | Td⁵air (°C) | Peak wavelength (nm) | Photolumines cence yield |
|---|---|---|---|---|---|---|---|---|---|---|---|---|---|---|
| Example 1 NTCDA/MBCHA (mix) | 1.942 | 376 | 45.2 | 0.0343 | 2.96 | 1.51 | 20.7 | 0.97 | 73.3 | 385 | 465 | 403 | 406 | 0.0143 |
| Example 2 NTCDA50;CBDA50/MBCHA | 0.761 | 340 | 55.6 | 0.0178 | 2.81 | | | | 77.4 | 384 | 432 | 382 | 404 | 0.0341 |
| Example 3 NTCDA10;CBDA90/MBCHA | 0.638 | 337 | 62.6 | 0.0093 | 2.69 | | | | 84.4 | 380 | 420 | 381 | 402 | 0.0878 |
| Example 4 NTCDA2;CBDA98/MBCHA | 0.693 | 336 | 63.6 | 0.0052 | 2.66 | | | | 86.5 | 292 | 427 | 372 | 401 | 0.1479 |
| Example 5 NTCDA/MBMCHA | 2.00 | 347 | 51.0 | 0.0158 | 2.88 | 2.22 | 14.0 | 1.57 | 72.9 | 384 | 448 | 381 | 404 | 0.0213 |
| Example 6 NTCDA/t-MBCHA | 1.503 | 394 | 46.2 | 0.0369 | 2.97 | | | | 75.4 | 385 | 466 | 405 | 404 | 0.0198 |
| Comparative Example 2 1458NTCDA O;CBDA901MBCHA | 0.646 | 334 | 60.7 | 0.0015 | 2.69 | | | | 31.7 | 389 | 426 | 379 | 520 | 0.0008 |

### Industrial Applicability

A polyimide film of the present invention formed on the surface of a glass substrate or the like has a high blue photoluminescence quantum yield and also has a high glass transition temperature and toughness. Therefore, the polyimide film of the present invention can be used as a blue-light-emitting element for organic EL displays.

## Claims

1. A blue-light-emitting element comprising a polyimide containing a repeating unit represented by formula (1): 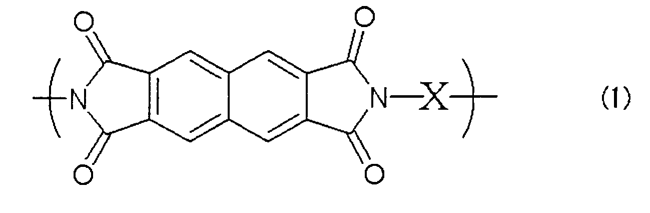 (wherein X represents a divalent alicyclic hydrocarbon group having 6 to 24 carbon atoms.)

2. The blue-light-emitting element comprising a polyimide according to Claim 1, wherein the polyimide is prepared by performing an imidization reaction of a polyimide precursor having an intrinsic viscosity of 0.5 dl/g or more under heating or in the presence of a dehydrating agent.

3. The blue-light-emitting element comprising a polyimide according to Claim 1, wherein the polyimide has a glass transition temperature of 250°C or higher and toughness.
